# EUROPEAN PATENT SPECIFICATION

(11) **EP 2 877 340 B1**
(45) Date of publication and mention of the grant of the patent: **06.09.2017**
(21) Application number: 13773364.8
(22) Date of filing: 22.07.2013
(51) Int. Cl.: B29D 30/62, B29D 30/16, B29C 47/92, H03K 17/955

(54) **PROCESS AND APPARATUS FOR BUILDING TYRES**
VERFAHREN UND VORRICHTUNG ZUR REIFENHERSTELLUNG
PROCÉDÉ ET DISPOSITIF POUR LA FABRICATION DE PNEUMATIQUES

(30) Priority: 25.07.2012 IT PD20120229; 27.07.2012 US 201261676497 P
(43) Date of publication of application: 03.06.2015
(73) Proprietor: Pirelli Tyre S.p.A., 20126 Milano (IT)
(72) Inventor: LO PRESTI, Gaetano, I-20126 Milano (IT); BALLABIO, Michele, I-20126 Milano (IT); BELFORTE, Guido, I-10129 Torino (IT); CARELLO, Massimiliana, I-10129 Torino (IT); IVANOV, Alexandre, I-10129 Torino (IT)
(74) Representative: Susanetto, Carlo
(86) International application number: PCT/IB2013/056004
(87) International publication number: WO 2014/016755

(56) References cited:
- WO-A1-2004/022322
- WO-A1-2010/114165
- US-A- 3 853 064
- US-A- 5 818 129
- US-A- 5 933 288
- US-B1- 6 339 376

## Description

The present invention relates to a process for building a tyre and an apparatus arranged to operate according to this process.

The aforesaid invention also relates to a method for controlling the rotation of a forming drum during the building of a tyre.

A tyre generally comprises a carcass structure shaped toroidally about an axis of rotation and comprising at least one carcass ply having terminal flaps engaged in corresponding anchoring annular structures, each of these structures normally being formed by at least one substantially circumferential annular insert on to which is applied at least one filler insert tapering radially away from the axis of rotation.

In a position radially outside the carcass structure there is provided a belt structure comprising one or more belt layers, located so as to radially overlap each other and the carcass ply, having textile or metal reinforcing cords orientated in a criss-cross arrangement and/or substantially parallel to the circumferential direction of extension of the tyre.

In a position radially outside the belt structure there is applied a tread band, which is made of elastomeric material, as are other semifinished products of which the tyre is composed.

Between the tread band and the belt structure there may be interposed what is known as a "underlayer", also made of elastomeric material, having properties which ensure the permanent bonding of the tread band.

On the lateral surfaces of the carcass structure, respective sidewalls of elastomeric material are also applied, each extending from one of the lateral edges of the tread band to the position of the respective anchoring annular structure.

In tyres of the tubeless type, the carcass ply is covered internally with a layer of elastomeric material, preferably butyl-based, usually known as a "linear", which has excellent characteristics of impermeability to air.

In tyres of the self-supporting type or those for other special uses, the carcass structure may also be provided with auxiliary support inserts of elastomeric material, located in an axially inner position relative to each of the sidewalls. These auxiliary support inserts, usually known as "sidewall inserts", serve to withstand the loads transmitted to the wheel in case of accidental deflation of the tyre, in order to allow the vehicle to continue running in safe conditions.

The term "elastomeric material" denotes a composition comprising at least one elastomeric polymer and at least one reinforcing filler. Preferably, this composition further comprises additives such as a cross-linking agent and/or a plasticizer. Because of the presence of the cross-linking agent, the elastomeric polymer can be cross-linked by heating so as to form the final product.

The term "elastomeric material component" of the tyre denotes any part of the tyre made of elastomeric material only (for example, a tread band, sidewalls, a liner, an under-liner, fillers in the bead area, sidewall inserts in self-supporting tyres, anti-abrasion inserts, reinforcing inserts, an underlayer of the belt structure, an underlayer of the tread, etc.), or a portion thereof, or the assembly formed by two or more of the aforesaid parts or portions thereof.

The term "component of a tyre" denotes any functional part of the tyre (for example, a tread band, sidewalls, a liner, an under-liner, fillers in the bead area, sidewall inserts in self-supporting tyres, anti-abrasion inserts, reinforcing inserts, an underlayer of the belt structure, an underlayer of the tread, a carcass ply or plies, a belt strip or strips, reinforcements strengthened with textile or metal cords, etc.), or a portion thereof, or the assembly formed by two or more of the aforesaid parts or portions thereof. The term "elongated element" denotes an element of elastomeric material extending predominantly in its longitudinal direction.

WO 01/36185, in the name of the present applicant, describes a robot arm which imparts to a toroidal support a circumferential distribution motion about its own geometric axis, simultaneously with controlled transverse distribution displacements in front of a member for delivering a continuous elongated element of elastomeric material. The continuous elongated element therefore forms a plurality of turns, the orientation and mutual overlapping of which are managed so as to control the variations in thickness to be imparted to a component of a tyre being built, on the basis of a predetermined deposition layout preset in an electronic computer. The rotation of the toroidal support is managed so as to obtain a peripheral application rate greater than the theoretical rate of supply of the continuous elongated element, this rate being capable of being increased or decreased as necessary to form turns with a reduced or increased cross section, respectively.

WO 2004/022322, in the name of the present applicant, describes a process for building a tyre in which the output of the continuous elongated element from an extruder is detected in a general way by an optical device.

US 5,933,288 discloses a proximity switching system for an electronic equipment, in particular for a sealed and portable battery operated equipment, wherein the switch is entirely located within a housing of the equipment, without apertures in the housing.

In the context of these processes, the applicant felt the need to determine precisely the exact moment of the output of the continuous elongated element from the aperture formed on the head of the extruder, in such a way that, with due consideration of the speed of extrusion of the continuous elongated element (a value which is known, since it can be derived directly from a process parameter of the extruder) and the known distance of the extruder from the forming drum, the rotation of the forming drum can be started at the most appropriate instant of time.

In a preliminary stage, the applicant has ascertained that the provision of an optical device according to the teachings of WO 2004/022322 would be a poorly practical solution in a real industrial tyre building process. This is because this type of sensor has proven to be unreliable, since it is excessively sensitive to other elements of the building process, including, primarily, problems of cleanliness due to the presence of fumes and dust which are at least partially created by the same process of extrusion of the continuous elongated element.

The applicant has also observed that the free space around the head of the extruder is particularly limited because of the presence of accessory devices, such as head cleaning devices for removing residues of elastomeric material, or devices for guiding the continuous elongated element towards the forming drum.

The applicant has therefore verified that, because of the considerable dimensions of an optical device and the necessity of providing a transmitter of the optical signal and a receiver of the optical signal in mutual alignment and on opposite sides of the aperture from which the continuous elongated element is output, the positioning of the device relative to the extruder head is particularly complicated.

The applicant has therefore perceived that, in order to detect exactly the moment of output of a continuous elongated element, it is necessary to structure the process in a functionally different manner by using detector devices which have smaller dimensions, while being able to operate effectively and reliably at the extruder head without being affected over time by the operational and environmental conditions typical of these processes, characterized by the presence of fumes and dust and of accessory mechanical devices operating at the extruder head.

In particular, the applicant has observed that the presence or absence of the continuous elongated element outgoing from the extruder head modifies the characteristics of the environment in which the aforesaid continuous elongated element may or may not be present, this environment including the extruder head. In particular, the applicant has discovered a significant modification of the electromagnetic characteristics of the aforesaid environment.

More precisely, the applicant has found that the presence of the continuous elongated element outgoing from the head of an extruder modifies the electrical permittivity of a portion of the volume adjacent to the extruder head, and that by using a sensor capable of detecting the variation of this characteristic it is possible to determine precisely the moment of output of the continuous elongated element from the extruder head.

In particular, in a first aspect, the invention relates to a process for building a tyre according to claim 1.

The applicant believes that, by operating according to a process having these characteristics, optimal synchronization is obtained between the start of the rotation of the forming drum and the arrival of the continuous elongated element outgoing from the head of the extruder, and, above all, the effectiveness and precision of this operation is maintained in a reliable way over time, without the need for continual adjustment and maintenance and without the need for further modification of the configuration of the existing apparatus. Furthermore, all of these benefits are achieved without any particularly large financial investments.

In addition the claimed process permits effective use of the extruder head, typically made of metallic material, to form, together with the conductive element of the resonant circuit, a distributed capacitive element, thereby making the extruder head part of the resonant circuit itself.

In a second aspect, the invention relates to apparatus for building a tyre according to claim 7.

The applicant believes that an apparatus having these characteristics can be used to detect the variation of electrical permittivity in a region of space including the extruder head, the aforesaid variation being caused by the presence of the continuous elongated element outgoing from the aperture of the extruder, this element, being formed from elastomeric material, having an electrical permittivity substantially different from that of the medium (typically air) which surrounds the extruder head when the elongated element is not extruded therefrom. Thus, a variation is created in the natural resonant frequency of the resonant circuit, and can be measured effectively by means of a suitable analysis circuit.

The output of the continuous elongated element from the extruder head is therefore detected in a precise and reliable manner.

Furthermore, owing to its particularly small dimensions, the electromagnetic sensor forming part of the apparatus according to the invention can be placed on the head in a position near the aperture of the extruder, without interfering in any way with the correct operation of the extruder or its accessory devices.

In addition, the aforesaid electromagnetic sensor can be mounted on the head by extremely simple operations.

In at least one of the aforesaid aspects, the present invention can have at least one of the following preferred characteristics. Preferred embodiments of the invention are defined in the dependent claims.

Preferably, said power supply circuit comprises a current or voltage generator and a first connecting element of a capacitive or inductive type connected to said generator to energize said resonant circuit.

According to a preferred embodiment, said parameter is a voltage induced by said resonant circuit in an analysis circuit associated with said resonant circuit.

This characteristic enables the variations of the electrical permittivity characteristics of a region adjacent to the extruder head to be measured in an operationally simple and accurate manner.

Preferably, said resonant circuit has a first natural resonant frequency measured in the absence of said continuous elongated element outgoing from said aperture and a second natural resonant frequency measured in the presence of said continuous elongated element outgoing from said aperture.

Preferably, said resonant circuit is energized by means of a power supply circuit, which in turn is supplied with a variable electric current having an operating frequency in the range from 80% of the smaller of said first and second natural resonant frequencies to 120% of the greater of said first and second natural resonant frequencies.

In this way, the variation in the natural resonant frequency of the resonant circuit causes a substantial variation of the induced voltage, which can therefore be measured more easily in the analysis circuit.

Indeed, the applicant has observed that the values of induced voltage as a function of the variation of the frequency of the current injected into the power supply circuit form a bell curve, with one peak (maximum or minimum) at the natural resonant frequency of the resonator and with its ends flattened towards zero.

Consequently, the displacement of the natural resonant frequency of the resonator, manifested in a displacement of the peak of the aforementioned curve, results in a very small, and therefore difficult to detect, deviation of the induced voltage at frequencies remote from the natural resonant frequency.

Preferably, said resonant circuit is energized by means of a power supply circuit which in turn is supplied with an electric current having an operating frequency in the range from about 200 MHz to about 800 MHz.

According to a further preferred characteristic, said resonant circuit is energized by means of a power supply circuit which in turn is supplied with an electric current having a power in the range from about 1 mW to about 1 W, and even more preferably in the range from about 10 mW to about 100 mW.

In this way an electromagnetic field of sufficient strength is obtained in the immediate vicinity of the extruder head, without creating disturbances in the apparatus surrounding the extruder or the forming drum, and without wasting energy.

In a first preferred embodiment, said parameter has a first mean value and a first range of variation about said first mean value detected in the absence of said continuous elongated element outgoing from said aperture, and a second mean value and a second range of variation about said second mean value detected in the presence of said continuous elongated element outgoing from said aperture, said variation of said parameter being detected when said parameter assumes a value between said first and second mean values and outside said first range of variation.

More preferably, said variation of said parameter is detected when said parameter assumes a value equal to said first mean value increased by at least 50% of the difference between said second mean value and said first mean value.

By providing this characteristic, it is possible to anticipate the stabilization of the variation of the natural resonant frequency of the resonant circuit and therefore the stabilization of the variation of the induced voltage, thus identifying the output of the elongated element from the aperture of the extruder in an extremely rapid way.

This is so because, if the variation of the parameter about the first mean value (in other words, the "background noise") relating to the absence of the elongated element outgoing from the aperture of the extruder remains within a first range of variation which is substantially limited relative to the second mean value, the measurement of a value of the parameter in the range between the first and second mean values but outside the first range of variation may reasonably be considered to be indicative of the output of the elongated element from the aperture of the extruder and not to be attributable to the background noise, even if the variation of the electrical permittivity characteristics is not yet complete (for example, because the elongated element has not yet become stably present in the whole of the region subject to the electromagnetic field of the resonator).

According to a preferred alternative embodiment, said parameter has a first mean value and a first range of variation about said first mean value detected in the absence of said continuous elongated element outgoing from said aperture, and a second mean value and a second range of variation about said second mean value detected in the presence of said continuous elongated element outgoing from said aperture, and said variation of said parameter is detected when the value of said parameter reaches said second mean value and remains within said second range of variation for a minimum continuous period in the range from about 0.1 s to about 1 s.

By following this operating procedure, it is possible to determine in a reliable way the occurrence of a variation of the electrical permittivity characteristics in the region adjacent to the extruder head, thereby also establishing with reasonable certainty the output of the elongated element from the aperture of the extruder.

Preferably, provision is also made to perform at least one of the following actions:
- measuring pressure levels within said head,
- detecting a variation of said pressure levels within said head caused by the extrusion of said continuous elongated element from said aperture, thus determining the presence of said continuous elongated element outgoing from said aperture,
- after a predetermined period following said detection of the variation of said pressure levels, checking whether said forming drum has been put into rotation, and,
- if said forming drum has not yet been put into rotation, putting said forming drum into rotation and/or generating an alarm signal indicating a malfunction of said electromagnetic sensor.

Thanks to this feature, it is provided for a double monitoring of the output of the elongated element from the extruder head as well as monitoring of the operation of the electromagnetic sensor. In fact, the applicant has found that, although the measurement of the variation of the internal pressure of the head is generally less accurate and precise in determining the moment of output of the elongated element from the aperture of the extruder than is the measurement of the variation of the electromagnetic field, it still provides an independent system for detecting the elongated element outgoing from the aperture of the extruder, since it is correlated solely with the mechanical action of extrusion. Therefore, this system can be effectively configured as an auxiliary control system for controlling the start of the rotation of the forming drum following the extrusion of the elongated element, and also as a system for checking the correct operation of the electromagnetic sensor.

Preferably, said forming drum is put into rotation within a period in the range from about 0 s to about 7 s following the detection of said variation of said parameter.

Thus the speed of the continuous elongated element arriving at the outer surface of the forming drum is correctly synchronized with the peripheral speed of this surface. The delay time before the actuation of the forming drum is also related to its distance from the extruder head and the speed of extrusion of the continuous elongated element.

Preferably, said current or voltage generator generates an electric current at a fixed operating frequency.

Even more preferably, said operating frequency is in the range from about 200 MHz to about 800 MHz.

Preferably, said generator supplies said power supply circuit with an electric current having a power in the range from about 1 mW to about 1 W. Preferably, said at least one conductive element is strip-shaped.

It is also preferable for said at least one conductive element to extend from a first end near said first connecting element to a second end near said aperture.

Thus the resonant circuit is structured in the most effective way to create a sensitive electromagnetic field at the aperture of the extruder.

According to a further preferred characteristic, said at least one conductive element has a length in the range from about 5 mm to about 50 mm.

This characteristic makes it possible to determine the values of natural resonant frequency of the resonant circuit in the most suitable way. Preferably, a greater part of said at least one conductive element is positioned on an opposite surface of said support from said head.

This characteristic makes it possible to provide the conductive element on the support of dielectric material by using printed circuit technology, thus reducing production time and costs.

According to a preferred characteristic, said support has a thickness at the position of said at least one conductive element in the range from about 0.2 mm to about 5 mm.

Thus it is possible to design the functional characteristics of the extruder head in the most correct way as a component of the distributed capacitive element of the resonant circuit.

Preferably, said support is sheet-like and comprises a first reference surface resting on an upper surface of said head and a second reference surface incident with said first reference surface and resting on a front surface of said head wherein said aperture opens.

This facilitates the positioning and mounting of the electromagnetic sensor on the extruder head.

According to a further preferred characteristic, said second end of said at least one conductive element is positioned at a distance from said aperture in the range from about 0.5 mm to about 5 mm.

This advantageously enables a significant electromagnetic field to be provided in the immediate vicinity of the aperture without interference with the output of the elongated element therefrom.

Preferably, also, said resonant circuit comprises a first and a second conductive element extending parallel to each other.

This has been found to be the most effective configuration for generating an electromagnetic field which is sufficiently sensitive to the variations of electrical permittivity in the immediate vicinity of the aperture of the extruder.

In a particularly preferred way, said first conductive element and said second conductive element are spaced apart from each other by a minimum distance in the range from about 0.5 mm to about 5 mm.

According to a further preferred embodiment, said at least one conductive element is short-circuited at said first end.

In this way a quarter-wave resonator configuration is obtained, with a maximum electric field amplitude at the second end of the conductive elements, and therefore in the proximity of the aperture of the extruder. This advantageously makes it possible to detect in the best way the variation of the electrical permittivity characteristics caused by the presence of the elongated element.

In an alternative embodiment, said at least one conductive element is not short-circuited at either of its two ends.

In this way a half-wave resonator configuration is obtained, which, once again, has a maximum electric field amplitude at the second end of the conductive elements.

According to a further preferred embodiment, said first connecting element is physically connected to said at least one conductive element.

In an alternative embodiment, said first connecting element is physically separated from said at least one conductive element.

Preferably, said first connecting element is of the inductive type.

More preferably, said first connecting element comprises at least one turn. In an alternative embodiment, said first connecting element is of the capacitive type.

The applicant considers that the capacitive element is simpler, whereas the inductive element is more stable, and the most suitable solution is to be determined on a case-by-case basis.

Preferably, said analysis circuit is connected to said first connecting element.

In an alternative embodiment, said analysis circuit comprises a second connecting element, separate from said first connecting element, by means of which it is associated with said resonant circuit.

The applicant considers that the greater simplicity of the configuration with one connecting element may be replaced by the configuration with two connecting elements in some cases in order to meet requirements of greater precision.

Preferably, said analysis circuit comprises a rectifier.

In this way it is possible to measure in an appropriate way the voltage induced by the resonant circuit.

Preferably, said parameter is the voltage induced by said resonant circuit in said analysis circuit.

Preferably, said variation of the electrical permittivity characteristics is detected by the analysis of a parameter associated with a resonant circuit designed to generate an electromagnetic field in said region.

Preferably, said electromagnetic field is generated by energizing said resonant circuit.

Preferably, said analysis of said parameter is performed by measuring the voltage variation induced in an analysis circuit associated with said resonant circuit.

The characteristics and advantages of the invention will be made clearer by the detailed description of some preferred examples of embodiment thereof, illustrated, for the purposes of guidance and in a non-limiting way, with reference to the attached drawings, in which:
- Figure 1 is a schematic view of a first exemplary embodiment of an apparatus for building a tyre, arranged to operate according to the method and process of the present invention;
- Figure 2 is a view on an enlarged scale and in frontal perspective of a component of the apparatus of Figure 1;
- Figures 3 and 4 are, respectively, a perspective view from above and from below of a detail of Figure 2;
- Figures 5a and 5b are, respectively, an outline circuit diagram and an equivalent circuit diagram of the electromagnetic sensor of Figure 2;
- Figure 6 is an example of a graph showing the variation of the curve of induced voltage as a function of the operating frequency (the resonance curve) of an electromagnetic sensor of the apparatus of Figure 1, resulting from the extrusion of a continuous elongated element from an extruder of the apparatus of Figure 1;
- Figure 7 is a graph showing the variation of the induced voltage in an analysis circuit of an electromagnetic sensor of the apparatus of Figure 1, detected in a period of time including the output of a continuous elongated element from an extruder of the apparatus of Figure 1;
- Figure 8 is a representation of the variation of the electric field and the magnetic field along a component of the electromagnetic sensor of the apparatus of Figure 1;
- Figures 9a and 9b are, respectively, an outline circuit diagram and an equivalent circuit diagram of an electromagnetic sensor made according to a first variant embodiment of the apparatus of Figure 1; and
- Figures 10a and 10b are, respectively, an outline circuit diagram and an equivalent circuit diagram of an electromagnetic sensor made according to a second variant embodiment of the apparatus of Figure 1.

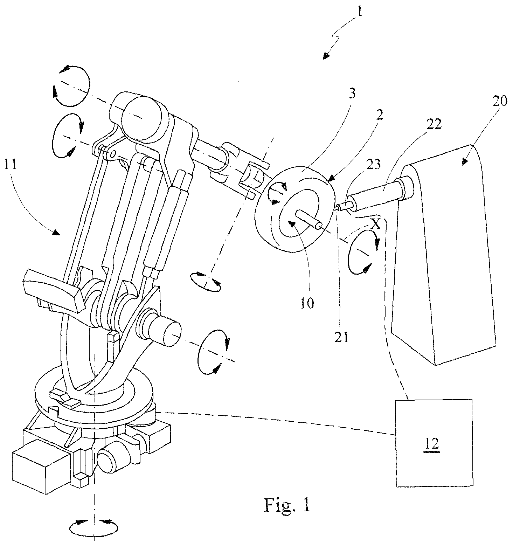

With initial reference to Figures 1 to 8, the number 1 indicates the whole of a first exemplary embodiment of an apparatus for building a tyre, arranged to operate according to the method and process of the present invention.

The apparatus 1 is preferably configured so as to supply an elastomeric material component of a tyre 10 being formed, for example a tread of the tyre, to a forming drum 2.

The forming drum 2 is known in itself, and has a substantially toroidal or cylindrical shape, on which a radially outer surface 3 is identified.

The forming drum 2 is mounted on a robot arm 11, preferably of the anthropomorphic type with at least three axes (seven in Fig. 1), capable of moving the drum and causing it to rotate about its own axis of rotation X. Preferably, the axis of rotation X substantially coincides with a principal axis which is the axis of axial symmetry.

The forming drum 2 is arranged to support the tyre 10 being formed, in such a way that the radially outer surface 3 of the tyre faces outwards and the axis of the tyre being formed coincides with the axis of rotation X of the forming drum 2.

It should be noted that said radially outer surface 3 may also comprise the radially outer surface of at least one other component, if required, of the tyre 10 being formed, radially superimposed on said forming drum.

The apparatus 1 further comprises an extruder 20, associated for operation with the forming drum 2, and arranged to deliver a continuous elongated element 21 of elastomeric material, which is distributed on the radially outer surface 3 while the forming drum 2 rotates about its own axis of rotation X.

The extruder 20 may be of any type suitable for the purpose and known in the art, and comprises a body 22, accommodating the members used for moving and heating the elastomeric mixture, and a head 23 from which the continuous elongated element 21 is delivered.

In particular, this element is delivered through an aperture 24, formed in the head 23 and shaped as a slit extending in a predominantly longitudinal direction.

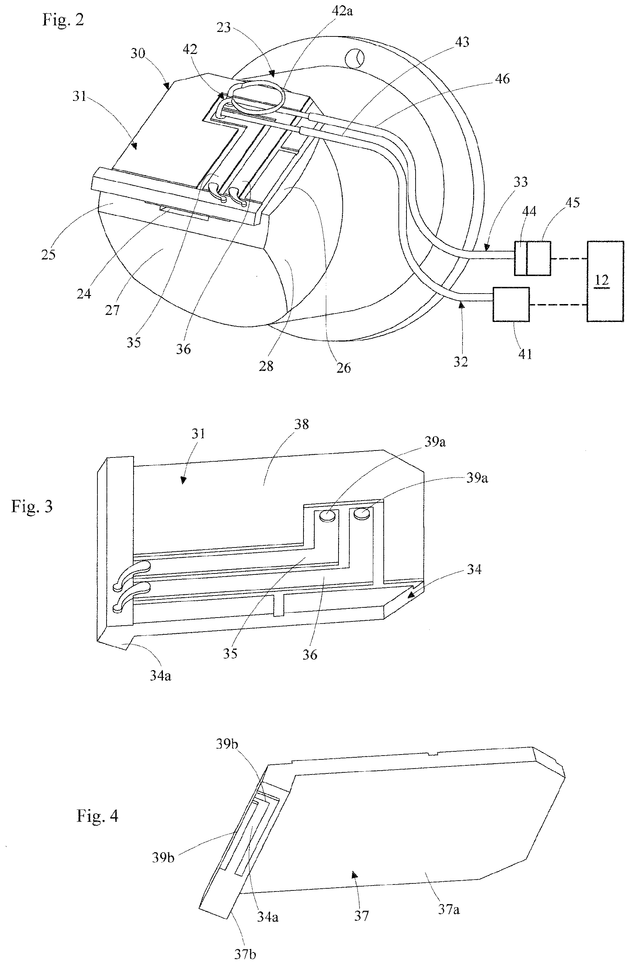

As can be seen more clearly in Figure 2, on the head 23 there is formed a front wall 25, in which the aperture 24 opens, a top wall 26 and an opposing bottom wall 27, closed by opposing lateral walls 28. Preferably, the top wall 26 and the bottom wall 27 are inclined symmetrically with respect to the front wall 25, thereby giving the head 23 a profile which tapers towards the front wall 25.

Examples of suitable extruders are described, for example, in WO 2004/022322 and WO2005/000559 in the name of the same applicant.

The apparatus 1 further comprises a control device 12, not shown in detail in the attached drawings, arranged to put the forming drum 2 into rotation as a function of the presence of the continuous elongated element 21 outgoing from the aperture 24.

A pressure sensor, not shown in the attached drawings, is also mounted inside the head 23 and is connected to the aforementioned control device 12, this sensor being capable of detecting any variations of pressure inside the head 23, caused, in particular, by the extrusion of the continuous elongated element 21 through the aperture 24.

In the bottom wall 27, and therefore in a position below the aperture 24, there may be provided an auxiliary nozzle arranged to use a jet of fluid, such as air, to lift the continuous elongated element 21 at the moment of its output from the aperture 24, in order to guide it in the best way towards the forming drum 2.

The auxiliary nozzle is orientated in such a way that the jet of lifting air is orientated along an inclined upward trajectory in a direction away from the front wall 25.

The presence of the continuous elongated element 21 outgoing from the aperture 24 is detected by means of an electromagnetic sensor 30 associated with the control device 12 and mounted on the head 23 at the position of the aperture 24.

The electromagnetic sensor 30 comprises, in its principal components, a resonant circuit indicated as a whole by 31 and positioned at the head 23 to generate an electromagnetic field in a portion of space surrounding the head 23, a power supply circuit 32 capable of energizing the resonant circuit 31, and an analysis circuit 33 capable of detecting the variation of the natural resonant frequency of the resonant circuit 31 as a function of the presence or absence of the continuous elongated element 21 from the aperture 24.

Looking now in detail at each of the components listed above, the resonant circuit 31 comprises a support 34, made of dielectric material, resting on the top wall 26 of the head 23, and a pair of conductive elements 35 and 36, adapted to generate the electromagnetic field and arranged on the support 34 in a position remote from the head 23.

The support 34 is strip-shaped, with a substantially constant thickness in the range from about 0.2 mm to about 5 mm. A first surface 37, resting directly on the head 23, and a second surface 38, opposite the first surface 37, are formed on the support 34.

Additionally, a first, flat, reference surface 37a, resting on the top surface 26 of the head 23, and a second reference surface 37b, incident with the first reference surface 37a and resting on the front surface 25 of the head 23, are formed on the first surface 37. Thus the support 34 has a predominant, substantially flat, portion, which rests on the upper surface 26 of the head 23 and has a projection 34a extending from the front side of the support 34 along the front wall 25 of the head 23.

The two conductive elements 35 and 36 are strip-shaped, with a predominant longitudinal dimension in the range from about 5 mm to 50 mm and a width in the range from about 0.2 mm to about 5 mm. They also extend so as to be substantially parallel to each other between a first end 39a and a second end 39b and are spaced apart by a distance in the range from about 0.5 mm to about 5 mm.

The two conductive elements 35, 36 are arranged to run from their first ends 39a, and for a predominant part of the element, over the second surface 38, while each second end 39b passes through the support 34 at the position of the projection 34a so as to open in the proximity of the aperture 24, at a distance from said aperture in the range from about 0.5 mm to about 15 mm, while continuing to be spaced apart from the head 23. The two conductive elements 35, 36 are short-circuited at their first ends 39a, so as to form a quarter-wave resonator with a peak electric field present at the second end 39b.

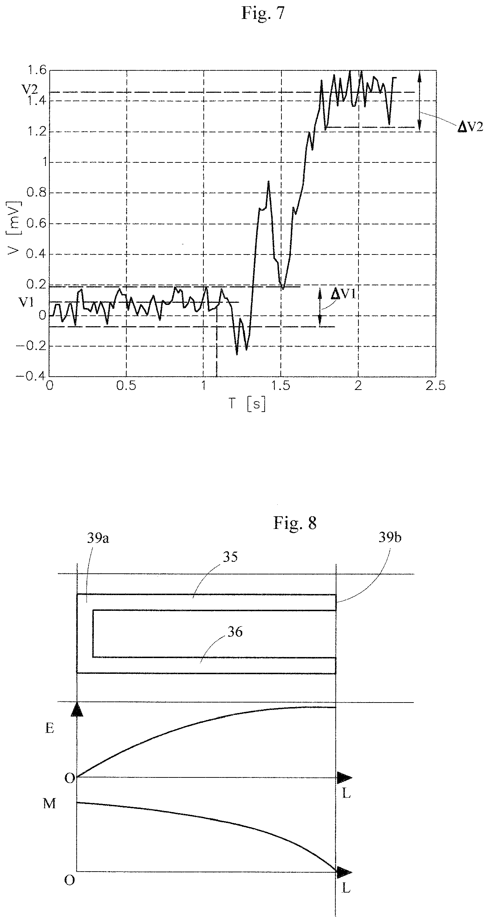

This situation is illustrated more clearly by the representation in Figure 8, where the amplitudes of the electric field E and of the magnetic field H are shown as a function of the longitudinal extension L of the two conductive elements 35 and 36 from the first end 39a to the second end 39b.

In variants not illustrated in the present description, provision is made either to short-circuit both ends 39a, 39b of the two conductive elements 35 and 36, or to short-circuit neither of them, thus producing a half-wave resonator in which the maximum value of the electric field appears in the median area of the conductive elements, or, respectively, at the opposing ends 39a, 39b.

The power supply circuit 32 substantially comprises a current or voltage generator 41 and a first connecting element 42 connected to the generator 41 via a coaxial cable 43.

The generator 41 is arranged to inject into the power supply circuit 32 an alternating electric current at a fixed operating frequency F, generally in the range from about 200 MHz to about 800 MHz, with a power in the range from about 1 mW to about 1 W.

The operating frequency F is chosen as a function of the characteristics of the resonant circuit 31, particularly the dimensional characteristics of the two conductive elements 35 and 36, which substantially determine the natural resonant frequency. The exact value of the latter is generally determined solely by the electrical permittivity characteristics of the portion of volume subject to the electromagnetic field generated by the resonant circuit 31, and therefore, if all the other variables remain unchanged, solely by the presence or absence of the continuous elongated element 21 outgoing from the aperture 24.

Therefore, the resonant circuit 31 has a first natural resonant frequency F1 measured in the absence of the continuous elongated element 21, in which the region immediately outside the aperture 24 is substantially composed of air, and a second natural resonant frequency F2, measured in the presence of the continuous elongated element 21, in which the region immediately outside the aperture 24 includes, in addition to air, an elastomeric polymer whose electrical permittivity characteristics differ substantially from those of air.

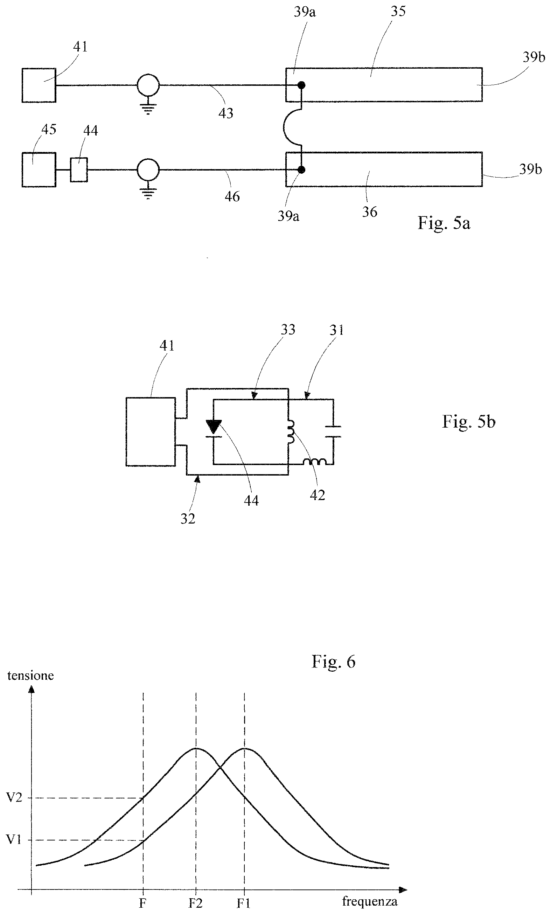

When the natural resonant frequencies F1 and F2 have been defined, the operating frequency F of the generator 31 is chosen so as to be in the range from 80% of the smaller of the first and second natural resonant frequencies F1, F2 to 120% of the greater of the first and second natural resonant frequencies F1 and F2 (Figure 6).

In the preferred example described herein, the operating frequency is about 625 MHz.

The first connecting element 42 is of the inductive type, and comprises a turn 42a physically connected to the first ends 39a of the conductive elements 35 and 36.

The analysis circuit 33 is directly connected to the turn 42a of the first connecting element 42, at the opposite end from the power supply circuit 32, via a coaxial cable 46, and comprises a rectifier diode 44 and an electronic circuit board 45 capable of detecting the voltage V induced in the circuit by the resonant circuit 31.

Again with reference to Figure 6, the voltage V induced in the analysis circuit 33 is a function of the operating frequency F and of the electrical permittivity characteristics of the region surrounding the resonant circuit 31.

When the operating frequency F has been chosen, the analysis circuit 33 detects a first mean value V1 and a second mean value V2, different from V1, in the absence and in the presence, respectively, of the continuous elongated element 21 outgoing from the aperture 24.

Depending on the characteristics of the electromagnetic sensor 30 and the head 23, the induced voltage V oscillates about the first mean value V1 or the second mean value V2, thus defining, respectively, a first range of variation ΔV1 and a second range of variation ΔV2 (Figure 7).

When the electromagnetic sensor 30 is put into operation, the generator 41 creates an electric current with an operating frequency F in the power supply circuit 32, capable of energizing the resonant circuit 31 via the connecting element 42. The electromagnetic field generated by the latter gives rise to an induced voltage V in the analysis circuit 33, this voltage initially being within the first range of variation ΔV1, which is measured by the circuit board 45.

Meanwhile, the pressure sensor positioned inside the head 23 measures a first pressure level P1.

At the moment when the extruder 20 is started, the partially melted elastomeric material is pushed into the head 23, thus causing a rise in the pressure inside the head to a level of P2, greater than P1, which is transmitted by the pressure sensor to the control device 12. The latter records the moment at which the increase of pressure from P1 to P2 is detected.

The elastomeric material then starts to pass out of the head 23 through the aperture 24, forming the continuous elongated element 21 and creating a variation in the electrical permittivity characteristics of the region in which the electromagnetic field generated by the resonant circuit 31 is present. Consequently, the voltage induced in the analysis circuit 33 is displaced rapidly towards the second mean value V2, as shown in Figure 7.

In the specific example described herein, the second mean value V2 is well outside the first range of variation DV1, such that the exact moment of the output of the continuous elongated element 21 from the aperture 24 can be determined when the induced voltage V departs from the first range of variation and is displaced towards the second mean value V2, for example when it assumes a value close to the first mean value V1 incremented by at least 50% of the difference between the second and the first mean values V2 and V1.

Alternatively, the moment of output of the continuous elongated element 21 is considered to be the point when the induced voltage V, measured in the analysis circuit 33, reaches the second mean value V2 and remains within the second range of variation ΔV2 for a minimum consecutive period of about 1 ms and preferably for a period in the range from about 0.1 s to about 1 s.

In both cases, the moment of output of the continuous elongated element 21 is transmitted by the sensor 30 to the control device 12, which, after a predefined time following this determination, typically less than 7 s and dependent on the distance between the extruder 20 and the forming drum 2 and on the extrusion speed of the extruder, causes the forming drum 2 to be put into rotation about its own axis of rotation X, in such a way that the continuous elongated element 21 is distributed on the radially outer surface 3 of the forming drum 2, thus forming a portion of a component of the tyre 10 being formed, such as a tread, by winding turns which are in a side by side relationship and/or partially overlapping.

If the control device 12 does not receive the signal from the electromagnetic sensor, indicating the determination of the output of the continuous elongated element 21 from the aperture 24, within a predetermined period following the detection of the variation of pressure inside the head 23, it proceeds to generate an alarm signal indicating a malfunction of the electromagnetic sensor 30, and puts the forming drum 2 into rotation.

The invention described above lends itself to numerous modifications and variants which may be provided by a person skilled in the art without departing from the scope of protection defined by the attached claims.

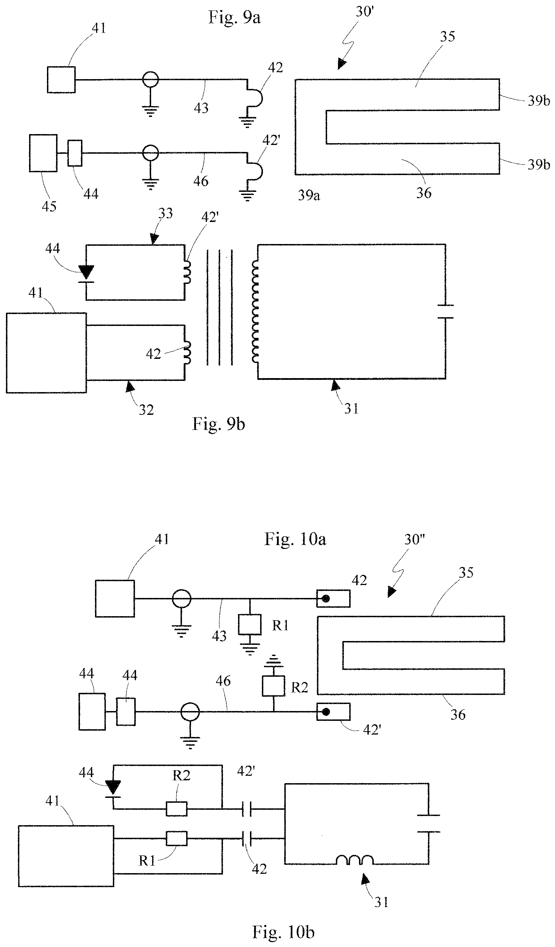

A first of these variants is shown schematically in Figures 9a and 9b, which represent an electromagnetic sensor 30' which differs from the electromagnetic sensor 30 in that it has a first connecting element 42, again of the inductive type, but physically separate from the conductive elements 35 and 36 and also from the analysis circuit 33. The latter, in turn, comprises a second connecting element 42', of the inductive type, associated separately with the resonant circuit 31.

The conductive elements 35 and 36 are short-circuited at their respective first ends 39a, so as to produce a quarter-wave configuration, as in the example described previously.

A second variant is shown schematically in Figures 10a and 10b, which represent an electromagnetic sensor 30" which differs from the electromagnetic sensor 30' in that it has a first connecting element 42 and a second connecting element 42' of the capacitive, rather than the inductive, type. Resistances R1 and R2 are suitably fitted in the earth connections of the power supply circuit 32 and in the analysis circuit 33.

Clearly, a person skilled in the art may produce further modifications and variants of the invention described above, in order to meet specific and contingent application requirements, all such variants and modifications falling within the scope of protection as defined in the subsequent claims.

## Claims

1. A process for building a tyre, comprising:
- providing a resonant circuit (31) of an electromagnetic sensor (30; 30'; 30") wherein the resonant circuit (31) comprises a support (34) of dielectric material resting on a head (23) of an extruder (20) and at least a first conductive element (35; 36) provided on said support (34) in a position spaced apart from said head (23) and capable of generating an electromagnetic field in a region comprising said head (23),
- energizing said resonant circuit (31), in such a way that said at least a first conductive element (35; 36) generates an electromagnetic field in a region comprising said head (23) of said extruder (20),
- measuring a parameter (V) associated with said resonant circuit and produced in response to said energizing of said resonant circuit, said parameter being a function of the electrical permittivity characteristics of said region,
- starting to extrude a continuous elongated element (21) made of elastomeric material through an aperture (24) formed in said head (23) of said extruder, in such a way that said electrical permittivity characteristics of said region are modified,
- detecting a variation of said parameter (V) caused by the modification of said electrical permittivity characteristics, thus determining the presence of said continuous elongated element (21) outgoing from said aperture,
- putting a forming drum (2) into rotation about its axis of rotation (X), at the end of a predetermined time interval after said detection of the variation of said parameter,
- distributing said continuous elongated element (21) along a radially outer surface (3) of said forming drum (2), thereby forming at least a portion of an elastomeric material component of a tyre by winding on turns which are in side by side relationship and/or at least partially overlapping.

2. A process according to Claim 1, wherein said parameter is a voltage induced by said resonant circuit (31) in an analysis circuit (33) associated with said resonant circuit.

3. A process according to Claim 1 or 2, wherein said resonant circuit has a first natural resonant frequency (F1) measured in the absence of said continuous elongated element (21) outgoing from said aperture and a second natural resonant frequency (F2) measured in the presence of said continuous elongated element (21) outgoing from said aperture, and wherein said resonant circuit (31) is energized by means of a power supply circuit (32) which in turn is supplied with a variable electric current having an operating frequency (F) in the range from 80% of the smaller of said first and second natural resonant frequencies to 120% of the greater of said first and second natural resonant frequencies.

4. A process according to any of the preceding claims, wherein said parameter (V) has a first mean value (V1) and a first range of variation (ΔV1) about said first mean value detected in the absence of said continuous elongated element (21) outgoing from said aperture, and a second mean value (V2) and a second range of variation (ΔV2) about said second mean value detected in the presence of said continuous elongated element (21) outgoing from said aperture, said variation of said parameter (V) being detected when said parameter assumes a value between said first and second mean values (V1, V2) and outside said first range of variation (ΔV1).

5. A process according to any of Claims 1 to 4, wherein said parameter has a first mean value (V1) and a first range of variation (ΔV1) about said first mean value detected in the absence of said continuous elongated element (21) outgoing from said aperture, and a second mean value (V2) and a second range of variation (ΔV2) about said second mean value detected in the presence of said continuous elongated element (21) outgoing from said aperture, and said variation of said parameter is detected when the value of said parameter (V) reaches said second mean value (V2) and remains within said second range of variation (ΔV2) for a minimum continuous period in the range from about 0.1 s to about 1 s.

6. A process according to any of the preceding claims, wherein provision is also made for:
- measuring pressure levels (P1, P2) within said head (23),
- detecting a variation of said pressure levels within said head caused by the extrusion of said continuous elongated element (21) from said aperture, thus determining the presence of said continuous elongated element outgoing from said aperture,
- after a predetermined period following said detection of said variation of said pressure levels, checking whether said forming drum (2) has been put into rotation, and,
- if said forming drum (2) has not yet been put into rotation, putting said forming drum (2) into rotation and/or generating an alarm signal indicating a malfunction of said electromagnetic sensor.

7. Apparatus (1) for building a tyre, comprising:
- an extruder (20) designed to deliver a continuous elongated element (21) through an aperture (24) formed in a head (23) of said extruder,
- a forming drum (2) capable of rotating about its own axis of rotation (X), said forming drum being associated with said extruder in order to receive, in the rotating condition, said continuous elongated element (21) outgoing from said aperture (24) upon its own radially outer surface (3),
- a control device (12) arranged to put said forming drum (2) into rotation as a function of the presence of said continuous elongated element (21) outgoing from said aperture (24),
**characterised in that** it comprises an electromagnetic sensor (30; 30'; 30") associated with said control device (12) and arranged to detect the presence of said continuous elongated element (21) outgoing from said aperture, said electromagnetic sensor including:
i) a resonant circuit (31) positioned at said head (23) to form an electromagnetic field in a region including said head,
ii) a power supply circuit (32) associated with said resonant circuit (31), and
iii) an analysis circuit (33) for analysing the response of said resonant circuit (31) designed to detect the variation of a parameter (V) associated with said resonant circuit, said parameter being a function of the electrical permittivity characteristics of said region, and **in that** said resonant circuit (31) comprises a support (34) of dielectric material resting on said head (23) and at least a first conductive element (35; 36) capable of generating said electromagnetic field and provided on said support (34) in a position spaced apart from said head (23).

8. Apparatus according to Claim 7, wherein said power supply circuit (32) comprises a current or voltage generator (41) and a first connecting element (42) of a capacitive or inductive type connected to said generator to energize said resonant circuit and wherein said at least a first conductive element (35; 36) extends from a first end (39a) near said first connecting element (42) to a second end (39b) near said aperture (24).

9. Apparatus according to Claims 7 or 8, wherein the greater part of said at least a first conductive element (35; 36) is positioned on a surface (38) of said support (34) opposite said head (23).

10. Apparatus according to any of Claims 7 to 9, wherein said support (34) is sheet-like and comprises a first reference surface (37a) resting on an upper surface (26) of said head and a second reference surface (37b) incident with said first reference surface (37a) and resting on a front surface (25) of said head wherein said aperture opens.

11. Apparatus according to any of Claims 7 to 10, wherein said resonant circuit (31) comprises a first and a second conductive element (35, 36) extending parallel to each other.

12. Apparatus according to any of Claims 8 to 11, wherein said at least a first conductive element (35; 36) is short-circuited at its first end (39a).

13. Apparatus according to any of Claims 8 to 11, wherein said at least a first conductive element (35; 36) is not short-circuited at either of its two ends (39a, 39b).

14. Apparatus according to any of Claims 7 to 13, wherein said power supply circuit (32) comprises a current or voltage generator (41) and a first connecting element (42) of a capacitive or inductive type connected to said generator to energize said resonant circuit and wherein said analysis circuit (33) is connected to said first connecting element (42).

15. Apparatus according to any of Claims 7 to 13, wherein said power supply circuit (32) comprises a current or voltage generator (41) and a first connecting element (42) of a capacitive or inductive type connected to said generator to energize said resonant circuit and wherein said analysis circuit (33) comprises a second connecting element (42'), separate from said first connecting element (42), by means of which it is associated with said resonant circuit (31).

## Patentansprüche

1. Verfahren zur Herstellung eines Reifens, das die folgenden Schritte umfasst:
Bereitstellen eines Schwingkreises (31) eines elektromagnetischen Sensors (30; 30'; 30"), wobei der Schwingkreis (31) einen Träger (34) aus dielektrischem Material umfasst, der auf einem Kopf (23) eines Extruders (20) ruht, sowie zumindest ein erstes leitendes Element (35; 36), das an dem Träger (34) in einer von dem Kopf (23) beabstandeten Position vorgesehen ist, und in der Lage ist, ein elektromagnetisches Feld in einem Bereich, der den Kopf (23) umfasst, zu erzeugen,
Erregen des Schwingkreises (31) auf solche Weise, dass das zumindest eine erste leitende Element (35; 36) ein elektromagnetisches Feld in einem Bereich, der den Kopf (23) des Extruders (20) umfasst, erzeugt,
Messen eines Parameters (V), der dem Schwingkreis zugeordnet ist und in Ansprechen auf die Erregung des Schwingkreises erzeugt wird, wobei der Parameter eine Funktion der elektrischen Durchlässigkeitseigenschaften des Bereichs ist,
Starten der Extrusion eines durchgehenden länglichen Elements (21) aus Elastomermaterial durch eine Öffnung (24), die in dem Kopf (23) des Extruders ausgebildet ist, auf solche Weise, dass die elektrischen Durchlässigkeitseigenschaften des Bereichs modifiziert werden,
Erfassen einer Schwankung des Parameters (V), die durch die Modifikation der elektrischen Durchlässigkeitseigenschaften verursacht werden, und somit Bestimmen des Vorhandenseins des durchgehenden länglichen Elements (21), das aus der Öffnung hervorgeht,
Versetzen einer Formungstrommel (2) in Drehung um ihre Drehachse (X), am Ende eines vorbestimmten Zeitintervalls nach der Erfassung der Schwankung des Parameters,
Verteilen des durchgehenden länglichen Elements (21) entlang einer radial äußeren Fläche (3) der Formungstrommel (2), wodurch zumindest ein Abschnitt einer Elastomermaterialkomponente eines Reifens durch Aufwickeln von Wicklungen gebildet wird, die in einer Beziehung Seite an Seite und/oder zumindest teilweise überlappend angeordnet sind.

2. Verfahren nach Anspruch 1, wobei der Parameter eine Spannung ist, die durch den Schwingkreis (31) in einem Analysekreis (33) induziert wird, der dem Schwingkreis zugeordnet ist.

3. Verfahren nach Anspruch 1 oder 2, wobei der Schwingkreis eine erste natürliche Resonanzfrequenz (F1) aufweist, die bei Fehlen des durchgehenden länglichen Elements (21), das aus der Öffnung hervorgeht, gemessen wird, und eine zweite natürliche Resonanzfrequenz (F2) aufweist, die bei Vorhandensein des durchgehenden länglichen Elements (21), das aus der Öffnung hervorgeht, gemessen wird, und wobei der Schwingkreis (31) mittels eines Leistungsversorgungskreises (32) erregt wird, der wiederum mit einem variablen elektrischen Strom mit einer Arbeitsfrequenz (F) in dem Bereich von 80 % der tieferen der ersten und zweiten natürlichen Resonanzfrequenzen bis 120 % der höheren der ersten und zweiten natürlichen Resonanzfrequenzen versorgt wird.

4. Verfahren nach einem der vorhergehenden Ansprüche, wobei der Parameter (V) einen ersten Mittelwert (V1) und einen ersten Schwankungsbereich (AV1) um den ersten Mittelwert aufweist, der bei Fehlen des durchgehenden länglichen Elements (21), das aus der Öffnung hervorgeht, erfasst wird, sowie einen zweiten Mittelwert (V2) und einen zweiten Schwankungsbereich (AV2) um den zweiten Mittelwert, der bei Vorhandensein des durchgehenden länglichen Elements (21), das aus der Öffnung hervorgeht, erfasst wird, wobei die Schwankung des Parameters (V) erfasstwird, wenn der Parameter einen Wert zwischen den ersten und zweiten Mittelwerten (V1, V2) und außerhalb des ersten Schwankungsbereichs (AV1) annimmt.

5. Verfahren nach einem der vorhergehenden Ansprüche, wobei der Parameter einen ersten Mittelwert (V1) und einen ersten Schwankungsbereich (AV1) um den ersten Mittelwert aufweist, der bei Fehlen des durchgehenden länglichen Elements (21), das aus der Öffnung hervorgeht, erfasst wird, sowie einen zweiten Mittelwert (V2) und einen zweiten Schwankungsbereich (AV2) um den zweiten Mittelwert, der bei Vorhandensein des durchgehenden länglichen Elements (21), das aus der Öffnung hervorgeht, erfasst wird, wobei die Schwankung des Parameters (V) erfasst wird, wenn der Wert des Parameters (V) den zweiten Mittelwert (V2) erreicht und für eine minimale durchgehende Zeitdauer in dem Bereich von etwa 0,1 s bis etwa 1 s innerhalb des zweiten Schwankungsbereichs (AV2) bleibt.

6. Verfahren nach einem der vorhergehenden Ansprüche, wobei auch Folgendes vorgesehen wird:
- Messen der Druckpegel (P1, P2) innerhalb des Kopfs (23),
- Erfassen einer Schwankung der Druckpegel innerhalb des Kopfs, die durch die Extrusion des durchgehenden länglichen Elements (21) aus der Öffnung verursacht werden, und somit Bestimmen des Vorhandenseins des durchgehenden länglichen Elements, das aus der Öffnung hervorgeht,
- Überprüfen, ob die Formungstrommel (2) in Drehung versetzt worden ist, nach einer vorbestimmten Periode, die auf die Erfassung der Schwankung der Druckpegel folgt, und,
wenn die Formungstrommel (2) noch nicht in Drehung versetzt worden ist, Versetzen der Formungstrommel (2) in Drehung und/oder Erzeugen eines Alarmsignals, das eine Fehlfunktion des elektromagnetischen Sensors anzeigt.

7. Vorrichtung (1) zur Herstellung eines Reifens, die Folgendes umfasst:
einen Extruder (20), der dazu konstruiert ist, ein durchgehendes längliches Element (21) durch eine Öffnung (24) auszugeben, die in einem Kopf (23) des Extruders ausgebildet ist,
eine Formungstrommel (2), die in der Lage ist, sich um ihre Drehachse (X) zu drehen, wobei die Formungstrommel dem Extruder zugeordnet ist, um in einem drehenden Zustand das durchgehende längliche Element (21), das aus der Öffnung (24) hervorgeht, an ihrer radial äußeren Oberfläche (3) aufzunehmen,
eine Steuereinrichtung (12), die angeordnet ist, um die Formungstrommel (2) in Drehung zu versetzen, als eine Funktion des Vorhandenseins des durchgehenden länglichen Elements (21), das aus der Öffnung (24) hervorgeht,
**dadurch gekennzeichnet, dass** sie einen elektromagnetischen Sensor (30; 30'; 30") umfasst, der der Steuereinrichtung (12) zugeordnet und dazu angeordnet ist, das Vorhandensein des durchgehenden länglichen Elements (21), das aus der Öffnung hervorgeht, zu erfassen, wobei der elektromagnetische Sensor umfasst:
i) einen Schwingkreis (31), der an dem Kopf (23) positioniert ist, um ein elektromagnetisches Feld in einem Bereich, der den Kopf umfasst, zu erzeugen,
ii) einen Leistungsversorgungskreis (32), der dem Schwingkreis (31) zugeordnet ist, und
iii) einen Analysekreis (33) zur Analyse einer Antwort des Schwingkreises (31), wobei der Analysekreis dazu konstruiert ist, die Schwankung eines Parameters (V), der dem Schwingkreis zugeordnet ist, zu erfassen, wobei der Parameter eine Funktion der elektrischen Durchlässigkeitseigenschaften des Bereichs ist,
und dadurch, dass der Schwingkreis (31) einen Träger (34) aus dielektrischem Material umfasst, der auf dem Kopf (23) ruht, sowie zumindest ein erstes leitendes Element (35; 36), das in der Lage ist, ein elektromagnetisches Feld zu erzeugen und an dem Träger (34) in einer von dem Kopf (23) beabstandeten Position vorgesehen ist.

8. Vorrichtung nach Anspruch 7, wobei der Leistungsversorgungskreis (32) einen Strom- oder Spannungsgenerator (41) und ein erstes Verbindungselement (42) eines kapazitiven oder induktiven Typs aufweist, das mit dem Generator verbunden ist, um den Schwingkreis zu erregen, und wobei das zumindest eine erste leitende Element (35; 36) sich von einem ersten Ende (39a) in der Nähe des ersten Verbindungselements (42) bis zu einem zweiten Ende (39b) in der Nähe der Öffnung (24) erstreckt.

9. Vorrichtung nach einem der Ansprüche 7 oder 8, wobei der größere Teil des zumindest einen ersten leitenden Elements (35; 36) an einer Oberfläche (38) des Trägers (34) gegenüber dem Kopf (23) positioniert ist.

10. Vorrichtung nach einem der Ansprüche 7 bis 9, wobei der Träger (34) blattförmig ist und eine erste Referenzoberfläche (37a), die auf einer oberen Oberfläche (26) des Kopfes ruht, und eine zweite Referenzoberfläche (37b) aufweist, die mit der ersten Referenzoberfläche (37a) zusammenfällt und an einer vorderen Oberfläche (25) des Kopfes, worin sich die Öffnung öffnet, ruht.

11. Vorrichtung nach einem der Ansprüche 7 bis 10, wobei der Schwingkreis (31) ein erstes und ein zweites leitendes Element (35, 36) umfasst, die sich parallel zueinander erstrecken.

12. Vorrichtung nach einem der Ansprüche 8 bis 11, wobei das zumindest eine erste leitende Element (35; 36) an seinem ersten Ende (39a) kurzgeschlossen ist.

13. Vorrichtung nach einem der Ansprüche 8 bis 11, wobei das zumindest eine erste leitende Element (35; 36) an keinem seiner beiden Enden kurzgeschlossen ist.

14. Vorrichtung nach einem der Ansprüche 7 bis 13, wobei der Leistungsversorgungskreis (32) einen Strom- oder Spannungsgenerator (41) und ein erstes Verbindungselement (42) eines kapazitiven oder induktiven Typs aufweist, das mit dem Generator verbunden ist, um den Schwingkreis zu erregen, und wobei der Analysekreis (33) mit dem ersten Verbindungselement (42) verbunden ist.

15. Vorrichtung nach einem der Ansprüche 7 bis 13, wobei der Leistungsversorgungskreis (32) einen Strom- oder Spannungsgenerator (41) und ein erstes Verbindungselement (42) eines kapazitiven oder induktiven Typs aufweist, das mit dem Generator verbunden ist, um den Schwingkreis zu erregen, und wobei der Analysekreis (33) ein zweites Verbindungselement (42') umfasst, das von dem ersten Verbindungselement (42) getrennt ist, und durch welches er dem Schwingkreis (31) zugeordnet ist.

## Revendications

1. Procédé pour construire un pneu comprenant le fait :
- de fournir un circuit résonnant (31) d'un capteur électromagnétique (30 ; 30' ; 30") où le circuit résonnant (31) comprend un support (34) de matériau diélectrique reposant sur une tête (23) d'une extrudeuse (20) et au moins un premier élément conducteur (35 ; 36) prévu sur ledit support (34) dans une position espacée de ladite tête (23) et capable de générer un champ électromagnétique dans une région comprenant ladite tête (23),
- d'exciter ledit circuit résonnant (31), de sorte que ledit au moins un premier élément conducteur (35 ; 36) génère un champ électromagnétique dans une région comprenant ladite tête (23) de ladite extrudeuse (20),
- de mesurer un paramètre (V) associé audit circuit résonant et produit en réponse à ladite excitation dudit circuit résonant, ledit paramètre étant une fonction des caractéristiques de permittivité électrique de ladite région,
- de commencer à extruder un élément allongé continu (21) réalisé en un matériau élastomère à travers une ouverture (24) formée dans ladite tête (23) de ladite extrudeuse, de sorte que lesdites caractéristiques de permittivité électrique de ladite région soient modifiées,
- de détecter une variation dudit paramètre (V) provoquée par la modification desdites caractéristiques de permittivité électrique, déterminant ainsi la présence dudit élément allongé continu (21) sortant de ladite ouverture,
- de mettre un tambour de formation (2) en rotation autour de son axe de rotation (X), à la fin d'un intervalle de temps prédéterminé après ladite détection de la variation dudit paramètre,
- de distribuer ledit élément allongé continu (21) le long d'une surface radialement externe (3) dudit tambour de formation (2), formant ainsi au moins une partie d'un composant en matériau élastomère d'un pneu par enroulement sur des spires qui sont côte à côte et/ou se chevauchent au moins partiellement.

2. Procédé selon la revendication 1, dans lequel ledit paramètre est une tension induite par ledit circuit résonnant (31) dans un circuit d'analyse (33) associé audit circuit résonnant.

3. Procédé selon la revendication 1 ou 2, dans lequel ledit circuit résonnant a une première fréquence de résonance propre (F1) mesurée en l'absence dudit élément allongé continu (21) sortant de ladite ouverture et une deuxième fréquence de résonance propre (F2) mesurée en présence dudit élément allongé continu (21) sortant de ladite ouverture, et dans lequel ledit circuit résonnant (31) est excité au moyen d'un circuit d'alimentation électrique (32) qui à son tour est alimenté en courant électrique variable ayant une fréquence de fonctionnement (F) se trouvant dans la plage allant de 80% de la plus petite desdites première et deuxième fréquences de résonance propres à 120% de la plus grande desdites première et deuxième fréquences de résonance propres.

4. Procédé selon l'une des revendications précédentes, dans lequel ledit paramètre (V) a une première valeur moyenne (V1) et une première plage de variation (ΔV1) autour de ladite première valeur moyenne détectée en l'absence dudit élément allongé continu (21) sortant de ladite ouverture, et une deuxième valeur moyenne (V2) et une deuxième plage de variation (ΔV2) autour de ladite deuxième valeur moyenne détectée en présence dudit élément allongé continu (21) sortant de ladite ouverture, ladite variation dudit paramètre (V) étant détectée lorsque ledit paramètre prend une valeur entre lesdites première et deuxième valeurs moyennes (V1, V2) et en dehors de ladite première plage de variation (ΔV1).

5. Procédé selon l'une des revendications 1 à 4, dans lequel ledit paramètre a une première valeur moyenne (V1) et une première plage de variation (ΔV1) autour de ladite première valeur moyenne détectée en l'absence dudit élément allongé continu (21) sortant de ladite ouverture, et une deuxième valeur moyenne (V2) et une deuxième plage de variation (ΔV2) autour de ladite deuxième valeur moyenne détectée en présence dudit élément allongé continu (21) sortant de ladite ouverture, et ladite variation dudit paramètre est détectée lorsque la valeur dudit paramètre (V) atteint ladite deuxième valeur moyenne (V2) et demeure dans ladite deuxième plage de variation (ΔV2) pendant une période continue minimale dans la plage allant d'environ 0,1 s à environ 1 s.

6. Procédé selon l'une des revendications précédentes, où il est également prévu :
- de mesurer des niveaux de pression (P1, P2) dans ladite tête (23),
- de détecter une variation desdits niveaux de pression dans ladite tête provoquée par l'extrusion dudit élément allongé continu (21) à partir de ladite ouverture, déterminant ainsi la présence dudit élément allongé continu sortant de ladite ouverture,
- de vérifier, après une période prédéterminée suivant ladite détection de ladite variation desdits niveaux de pression, si ledit tambour de formation (2) a été mis en rotation, et,
- de mettre ledit tambour de formation (2) en rotation et/ou de générer un signal d'alarme indiquant un dysfonctionnement dudit capteur électromagnétique, si ledit tambour de formation (2) n'a pas encore été mis en rotation.

7. Appareil (1) pour construire un pneu, comprenant :
- une extrudeuse (20) conçue pour délivrer un élément allongé continu (21) à travers une ouverture (24) formée dans une tête (23) de ladite extrudeuse,
- un tambour de formation (2) capable de tourner autour de son propre axe de rotation (X), ledit tambour de formation étant associé à ladite extrudeuse afin de recevoir, dans la condition de rotation, ledit élément allongé continu (21) sortant de ladite ouverture (24) sur sa propre surface radialement externe (3),
- un dispositif de commande (12) agencé pour mettre ledit tambour de formation (2) en rotation en fonction de la présence dudit élément allongé continu (21) sortant de ladite ouverture (24),
**caractérisé en ce qu'**il comprend un capteur électromagnétique (30 ; 30' ; 30") associé audit dispositif de commande (12) et agencé pour détecter la présence dudit élément allongé continu (21) sortant de ladite ouverture, ledit capteur électromagnétique comprenant :
i) un circuit résonnant (31) positionné au niveau de ladite tête (23) pour former un champ électromagnétique dans une région comportant ladite tête,
ii) un circuit d'alimentation électrique (32) associé audit circuit résonnant (31), et
iii) un circuit d'analyse (33) pour analyser la réponse dudit circuit résonant (31) conçu pour détecter la variation d'un paramètre (V) associé audit circuit résonant, ledit paramètre étant une fonction des caractéristiques de permittivité électrique de ladite région,
et **en ce que** ledit circuit résonnant (31) comprend un support (34) de matériau diélectrique reposant sur ladite tête (23) et au moins un premier élément conducteur (35 ; 36) capable de générer ledit champ électromagnétique et prévu sur ledit support (34) dans une position espacée de ladite tête (23).

8. Appareil selon la revendication 7, dans lequel ledit circuit d'alimentation électrique (32) comprend un générateur de courant ou de tension (41) et un premier élément de connexion (42) d'un type capacitif ou inductif connecté audit générateur pour exciter ledit circuit résonnant et dans lequel ledit au moins un premier élément conducteur (35 ; 36) s'étend d'une première extrémité (39a) proche dudit premier élément de connexion (42) à une deuxième extrémité (39b) proche de ladite ouverture (24).

9. Appareil selon la revendication 7 ou 8, dans lequel la plus grande partie dudit au moins un premier élément conducteur (35 ; 36) est positionnée sur une surface (38) dudit support (34) opposée à ladite tête (23).

10. Appareil selon l'une des revendications 7 à 9, dans lequel ledit support (34) est en forme de feuille et comprend une première surface de référence (37a) reposant sur une surface supérieure (26) de ladite tête et une deuxième surface de référence (37b) incidente avec ladite première surface de référence (37a) et reposant sur une surface avant (25) de ladite tête où ladite ouverture s'ouvre.

11. Appareil selon l'une des revendications 7 à 10, dans lequel ledit circuit résonant (31) comprend des premier et deuxième éléments conducteurs (35, 36) s'étendant parallèlement l'un à l'autre.

12. Appareil selon l'une des revendications 8 à 11, dans lequel ledit au moins un premier élément conducteur (35 ; 36) est court-circuité au niveau de sa première extrémité (39a).

13. Appareil selon l'une des revendications 8 à 11, dans lequel ledit au moins un premier élément conducteur (35 ; 36) n'est court-circuité au niveau d'aucune de ses deux extrémités (39a, 39b).

14. Appareil selon l'une des revendications 7 à 13, dans lequel ledit circuit d'alimentation électrique (32) comprend un générateur de courant ou de tension (41) et un premier élément de connexion (42) d'un type capacitif ou inductif connecté audit générateur pour exciter ledit circuit résonnant et dans lequel ledit circuit d'analyse (33) est connecté audit premier élément de connexion (42).

15. Appareil selon l'une des revendications 7 à 13, dans lequel ledit circuit d'alimentation électrique (32) comprend un générateur de courant ou de tension (41) et un premier élément de connexion (42) d'un type capacitif ou inductif connecté audit générateur pour exciter ledit circuit résonant et dans lequel ledit circuit d'analyse (33) comprend un deuxième élément de connexion (42'), séparé dudit premier élément de connexion (42), au moyen duquel il est associé audit circuit résonnant (31).
